# EUROPEAN PATENT APPLICATION

(11) **EP 2 012 182 A2**
(43) Date of publication of application: **07.01.2009**
(21) Application number: 08159077.0
(22) Date of filing: 26.06.2008
(51) Int. Cl.: G03F 7/00, G03F 7/031

(54) **Radiation-sensitive composition for forming color filter for solid-state image sensing device, color filter, and solid-state image sensing device**

(30) Priority: 28.06.2007 JP 2007170046; 25.09.2007 JP 2007247916
(71) Applicant: JSR Corporation, Tokyo 104-0045 (JP)
(72) Inventor: Naruse, Shingo, Chuo-ku Tokyo 104-0045 (JP); Miyazaki, Tomokazu, Chuo-ku Tokyo 104-0045 (JP); Naruse, Hidenori, Chuo-ku Tokyo 104-0045 (JP); Yoshizawa, Hideyuki, Chuo-ku Tokyo 104-0045 (JP); Yamaguchi, Yukari, Chuo-ku Tokyo 104-0045 (JP)
(74) Representative: TBK-Patent

(57) **Abstract**

There is provided a radiation-sensitive composition for forming a color filter used for a solid-state image sensing device excellent in resolution without generating residues and scumming on a silicon substrate or a silicon nitride substrate. The radiation-sensitive composition for forming the color filter for the solid-state image sensing device contains (A) a pigment, (B) a dispersant, (C) an alkali-soluble resin, (D) a polyfunctional monomer, (E) a photopolymerization initiator, and (F) a compound represented by the following formula (1): 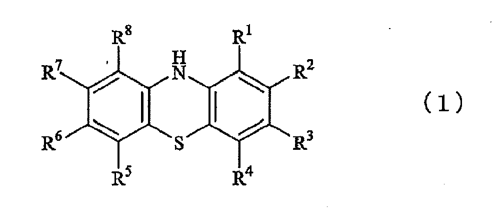 wherein R¹ to R⁸ each denote independently a hydrogen atom, a halogen atom or a monovalent organic group.
There is provided a color filter using the composition.

## Description

### BACKGROUND OF THE INVENTION

### Field of the Invention

The present invention relates to radiation-sensitive compositions for forming a color filter for a solid-state image sensing device, a color filter, and a solid-state image sensing device. More particularly, the present invention relates to a radiation-sensitive composition for a color filter which is useful for manufacture of a color filter used in a transmission-type or reflection-type solid-state image sensing device, a color filter formed from the composition, and a solid-state image sensing device equipped with the color filter.

### Description of the Related Art

For manufacturing a color filter used in a color liquid crystal display element by using a colored radiation-sensitive composition, there is usually known a method for forming pixel patterns of each color (for example, see JP-A-02-144502 and JP-A-03-53201), in which method a film of a colored radiation-sensitive composition is formed on a glass substrate or a glass substrate on which a light shielding layer of a desired pattern is beforehand formed, and is irradiated with radiation (hereinafter, referred to as "exposure") through a photomask having a desired pattern shape; the exposed film is developed to dissolve and remove unexposed parts thereof; and thereafter, the developed film is post-baked using a clean oven or a hot plate to form pixel patterns of each color.

On the other hand, for manufacturing a color filter used in a solid-state image sensing device, it is necessary to form a fine pixel pattern of about 1.0 to 3.0 µm and it is difficult for conventional colored radiation-sensitive compositions to meet the requirement. Further, in this case, since a substrate for forming a color filter is not a glass substrate but a silicon substrate or silicon nitride substrate, conventional colored radiation-sensitive compositions have a problem of causing residues and scumming on unexposed parts of a substrate; and since the adhesiveness to a substrate is insufficient, they have a problem of not providing a pixel pattern having a desired resolution.
Therefore, eagerly demanded is the development of a radiation-sensitive composition for forming a color filter used in a solid-state image sensing device, which composition does not cause residues and scumming on a silicon substrate or silicon nitride substrate and excels in resolution.

An object of the present invention is to provide a radiation-sensitive composition for forming a color filter used in a solid-state image sensing device, which composition does not cause residues and scumming on a silicon substrate or silicon nitride substrate and excels in resolution.

### SUMMARY OF THE INVENTION

The present inventors have conducted extensive studies on color filters, and have unexpectedly found that a radiation-sensitive composition containing (A) a pigment, (B) a dispersant, (C) an alkali-soluble resin, (D) a polyfunctional monomer, (E) a photopolymerization initiator and (F) a compound represented by the formula (1) described later does not cause residues and scumming on a silicon substrate or silicon nitride substrate and excels in resolution, and is useful especially for forming a color filter for a solid-state image sensing device. This finding has led to the completion of the present invention.

The present invention provides, firstly, a radiation-sensitive composition for forming a color filter for a solid-state image sensing device, which composition has a feature of containing (A) a pigment, (B) a dispersant, (C) an alkali-soluble resin, (D) a polyfunctional monomer, (E) a photopolymerization initiator and (F) a compound represented by the formula (1) described below.

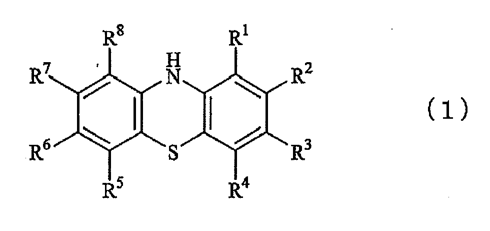

(in the formula (1), R¹ to R⁸ each denotes independently a hydrogen atom, a halogen atom or a monovalent organic group.)

The present invention provides, secondly, a color filter having a colored layer formed by using the above-mentioned radiation-sensitive composition.

The present invention provides, thirdly, a solid-state image sensing device equipped with the above-mentioned color filter.

Use of the radiation-sensitive composition of the present invention can form a color filter for a solid-state image sensing device allows not causing residues and scumming on a silicon substrate or silicon nitride substrate and enables to form a color filter for a solid-state image sensing device excellent in resolution.

### BRIEF DESCRIPTION OF THE DRAWING

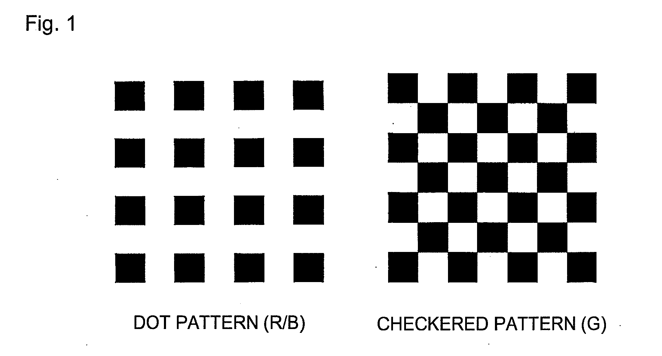

FIG. 1 is diagrams showing a dot pattern (R/B) and a checkered pattern (G).

### DETAILED DESCRIPTION OF THE PREFERRED EMBODIMENTS

Hereinafter, the present invention will be described in detail.
A radiation-sensitive composition for forming a color filter for a solid-state image sensing device according to the present invention contains (A) a pigment, (B) a dispersant, (C) an alkali-soluble resin, (D) a polyfunctional monomer, (E) a photopolymerization initiator and (F) a compound represented by the formula (1) described above.

(A) the pigment in the present invention is not especially limited, and may be either of an organic pigment and an inorganic pigment. Among them, especially an organic pigment is preferable since the color filter demands high-purity, high-transmittance coloring and heat resistance.

The organic pigment includes, for example, compounds classified as pigments in color index (C.I., issued by The society of Dyers and Colourists), specifically compounds given color index (C.I.) numbers as described below.

They include: C.I. Pigment Yellow 12, C.I. Pigment Yellow 13, C.I. Pigment Yellow 14, C.I. Pigment Yellow 17, C.I. Pigment Yellow 20, C.I. Pigment Yellow 24, C.I. Pigment Yellow 31, C.I. Pigment Yellow 55, C.I. Pigment Yellow 83, C.I. Pigment Yellow 93, C.I. Pigment Yellow 109, C.I. Pigment Yellow 110, C.I. Pigment Yellow 138, C.I. Pigment Yellow 139, C.I. Pigment Yellow 150, C.I. Pigment Yellow 153, C.I. Pigment Yellow 154, C.I. Pigment Yellow 155, C.I. Pigment Yellow 166, C.I. Pigment Yellow 168 and C.I. Pigment Yellow 211;

C.I. Pigment Orange 5, C.I. Pigment Orange 13, C.I. Pigment Orange 14, C.I. Pigment Orange 24, C.I. Pigment Orange 34, C.I. Pigment Orange 36, C.I. Pigment Orange 38, C.I. Pigment Orange 40, C.I. Pigment Orange 43, C.I. Pigment Orange 46, C.I. Pigment Orange 49, C.I. Pigment Orange 61, C.I. Pigment Orange 64, C.I. Pigment Orange 68, C.I. Pigment Orange 70, C.I. Pigment Orange 71, C.I. Pigment Orange 72, C.I. Pigment Orange 73 and C.I. Pigment Orange 74;

C.I. Pigment Red 1, C.I. Pigment Red 2, C.I. Pigment Red 5, C.I. Pigment Red 17, C.I. Pigment Red 31, C.I. Pigment Red 32, C.I. Pigment Red 41, C.I. Pigment Red 122, C.I. Pigment Red 123, C.I. Pigment Red 144, C.I. Pigment Red 149, C.I. Pigment Red 166, C.I. Pigment Red 168, C.I. Pigment Red 170, C.I. Pigment Red 171, C.I. Pigment Red 175, C.I. Pigment Red 176, C.I. Pigment Red 177, C.I. Pigment Red 178, C.I. Pigment Red 179, C.I. Pigment Red 180, C.I. Pigment Red 185, C.I. Pigment Red 187, C.I. Pigment Red 202, C.I. Pigment Red 206, C.I. Pigment Red 207, C.I. Pigment Red 209, C.I. Pigment Red 214, C.I. Pigment Red 220, C.I. Pigment Red 221, C.I. Pigment Red 224, C.I. Pigment Red 242, C.I. Pigment Red 243, C.I. Pigment Red 254, C.I. Pigment Red 255, C.I. Pigment Red 262, C.I. Pigment Red 264 and C.I. Pigment Red 272;

C.I. Pigment Violet 1, C.I. Pigment Violet 19, C.I. Pigment Violet 23, C.I. Pigment Violet 29, C.I. Pigment Violet 32, C.I. Pigment Violet 36 and C.I. Pigment Violet 38; C.I. Pigment Blue 15, C.I. Pigment Blue 15:3, C.I. Pigment Blue 15:4, C.I. Pigment Blue 15:6, C.I. Pigment Blue 60 and C.I. Pigment Blue 80; C.I. Pigment Green 7, C.I. Pigment Green 36 and C.I. Pigment Green 58; C.I. Pigment Brown 23 and C.I. Pigment Brown 25; and C.I. Pigment Black 1 and C.I. Pigment Black 7.
These organic pigments can be used singly or as a mixture of two or more.

Among these organic pigments, preferable is at least one selected from the group consisting of C.I. Pigment Yellow 83, C.I. Pigment Yellow 139, C.I. Pigment Yellow 138, C.I. Pigment Yellow 150, C.I. Pigment Yellow 180, C.I. Pigment Red 177, C.I. Pigment Red 242, C.I. Pigment Red 254, C.I. Pigment Blue 15:3, C.I. Pigment Blue 15:4, C.I. Pigment Blue 15:6, C.I. Pigment Green 7, C.I. Pigment Green 36, C.I. Pigment Green 58, C.I. Pigment Violet 23, C.I. Pigment Blue 60 and C.I. Pigment Blue 80.

In the present invention, the organic pigment may be purified for use by recrystallization, reprecipitation, solvent cleaning, sublimation or vacuum heating method or a combination method thereof.

The inorganic pigment includes, for example, titanium oxide, barium sulfate, calcium carbonate, zinc white, lead sulfate, yellow lead, zinc yellow, iron oxide red (red iron (III) oxide), cadmium red, ultramarine blue, Berlin blue, chrome oxide green, cobalt green, umber, titanium black, synthetic iron black and carbon black.
These inorganic pigments may be used singly or as a mixture of two or more.

Further, in the present invention, as the case may be, one or more of dyes and natural pigments may be used concurrently with the above-mentioned pigment.

In the present invention, the pigment can be used, as desired, by modifying the particle surface with a polymer. The polymer to modify the particle surface of the pigment includes, for example, a polymer described in JP-A-08-259876, and commercially available polymers or oligomers for dispersing various types of pigments.

The content of (A) the pigment in the present invention is preferably 0.5 to 20% by weight, more preferably 0.5 to 18% by weight, especially preferably 0.5 to 15% by weight with respect to the radiation-sensitive composition of the present invention in view of the developability, the resistances as a permanent film such as solvent resistance, chemical resistance and heat resistance, and the film strength.

(B) the dispersant to be used in the present invention includes, for example, suitable dispersants of cationic, anionic, nonionic and amphoteric types, but preferably includes dispersants (hereinafter, referred to as "amphoteric dispersant(s)") having an amine value (unit: mgKOH/g, hereinafter, the same) of 30 to 90 and an acid value (unit: mgKOH/g, hereinafter, the same) of 20 to 80. Here, the amine value refers to the mg number of KOH equivalent by weight to HCl necessary for neutralizing 1 g of a dispersant solid content; and the acid value refers to the mg numbers of KOH necessary for neutralizing 1 g of a dispersant solid content.

The amine value of the amphoteric dispersant is more preferably 40 to 80. In this case, with the amine value of the amphoteric dispersant of less than 30, the preservation stability of the obtained composition is likely to decrease; by contrast, with that exceeding 90, residues and scumming are likely to be generated.

The acid value of the amphoteric dispersant is more preferably 30 to 50. In this case, with the acid value of the amphoteric dispersant of less than 20, residues and scumming are likely to be generated; by contrast, with that exceeding 80, the preservation stability of the obtained composition is likely to decrease.

Commercially available amphoteric dispersants include Disperbyk-142 (nonvolatile component=60%, amine value=43, acid value=46, made by BYK Chemie GmbH), Disperbyk-145 (nonvolatile component=100%, amine value=71, acid value=76, made by BYK Chemie GmbH), Disperbyk-2001 (nonvolatile component=46%, amine value=19, acid value=29, made by BYK Chemie GmbH), Disperbyk-2020 (nonvolatile component=70%, amine value=38, acid value=35, made by BYK Chemie GmbH), Disperbyk-9076 (nonvolatile component=96%, amine value=44, acid value=38, made by BYK Chemie GmbH) and Solsperse 24000 (nonvolatile component=100%, amine value=42, acid value=25, made by Lubrizol Corp.).
In the present invention, the amphoteric dispersants may be used singly or as a mixture of two or more.

In the present invention, other dispersants may be used concurrently with the amphoteric dispersant.
The other dispersants include, for example, polyoxyethylene alkyl ethers such as polyoxyethylene lauryl ether, polyoxyethylene stearyl ether and polyoxyethylene oleyl ether; polyoxyethylene alkylphenyl ethers such as polyoxyethylene n-octylphenyl ether and polyoxyethylene n-nonylphenyl ether; polyethylene glycol difatty acid esters such as polyethylene glycol dilaurate and polyethylene glycol distearate; sorbitan fatty acid esters; fatty acid-modified polyesters; tertiary amine-modified polyurethane; polyethyleneimines; and besides, hereinafter as trade names, KP (made by Shin-Etsu Chemical Co., Ltd.), Polyflow (made by Kyoueisha Chemical Co., Ltd.), F top (made by Tochem Products Co., Ltd.), Megafac (made by Dainippon Ink & Chemicals, Inc.), Fluorad (made by Sumitomo 3M Ltd.), Asahi Guard and Surfron (made by Asahi Glass Co., Ltd.), Disperbyk-101, -103, -110, -111, -130, -160, -161, -162, -163, -164, -165, -166, -170, -180, -182 and -2000 (made by BYK-Chemie GmbH Japan), Solsperse S5000, 12000, 17000, 20000, 22000, 24000GR, 26000, 27000 and 28000 (made by Lubrizol Corp.), EFKA 46 and 47 (made by Efka Chemicals GmbH), and Ajisper PB-822 and 880(made by Ajinomoto Fine-Techno Co., Inc.).
These other dispersants may be used singly or as a mixture of two or more.

The content ratio of the other dispersant is preferably 0 to 75% by weight, more preferably 0 to 50% by weight with respect to the total amount of the amphoteric dispersant and the other dispersant in view of securing a favorable balance of the developability and preservation stability.
The content (in terms of solid content) of the amphoteric dispersant in the present invention is preferably 1 to 50 parts by weight, more preferably 3 to 30 parts by weight per 100 parts by weight of (A) the pigment in view of the preservation stability of a composition and the prevention of residue generation on a substrate.

(C) The alkali-soluble resin in the present invention is not especially limited as long as it acts on (A) the pigment as a binder, and is soluble to a liquid developer (especially preferably an alkali liquid developer) used in the developing process in manufacturing a color filter. Above all, an alkali-soluble resin having a carboxyl group is preferable and especially preferable is a copolymer (hereinafter, referred to as "carboxyl group-containing copolymer") of an ethylenic unsaturated monomer having at least one carboxyl group (hereinafter, referred to as "carboxyl group-containing unsaturated monomer") and another copolymerizable ethylenic unsaturated monomer (hereinafter, referred to as "copolymerizable unsaturated monomer") .

The carboxyl group-containing unsaturated monomer includes, for example:
unsaturated monocarboxylic acids such as (meth)acrylic acid, crotonic acid, α-chloroacrylic acid and cinnamic acid;
unsaturated dicarboxylic acids or their anhydrides such as maleic acid, maleic anhydride, fumaric acid, itaconic acid, itaconic acid anhydride, citraconic acid, citraconic acid anhydride and mesaconic acid;
mono[(meth)acryloyloxyalkyl] esters of di- or more polycarboxylic acids such as mono [2-(meth)acryloyloxyethyl] succinate and mono[2-(meth) acryloyloxyethyl] phthalate; and
mono(meth)acrylates of polymers having a carboxyl group and a hydroxyl group on their both terminals, such as ω-carboxypolycaprolactone mono(meth)acrylate.
Among these carboxyl group-containing unsaturated monomers, mono(2-acryloyloxyethyl) phthalate is commercially available under the trade name of M-5400 (Toagosei Co., Ltd.).
The carboxyl group-containing unsaturated monomers may be used singly or as a mixture of two or more.

The copolymerizable unsaturated monomers include, for example: maleimide;
N-substituted maleimides such as N-phenylmaleimide, N-o-hydroxyphenyl maleimide, N-m-hydroxyphenyl maleimide, N-p-hydroxyphenyl maleimide, N-benzylmaleimide, N-cyclohexylmaleimide, N-succinimidyl-3-maleimide benzoate, N-succinimidyl-4-maleimide butyrate, N-succinimidyl-6-maleimide caproate, N-succinimidyl-3-maleimide propionate and N-(acridinyl)maleimide;
aromatic vinyl compounds such as styrene, α-methylstyrene, o-vinyltoluene, m-vinyltoluene, p-vinyltoluene, p-chlorostyrene, o-methoxystyrene, m-methoxystyrene, p-methoxystyrene, p-hydroxy-α-methylstyrene, o-vinylbenzyl methyl ether, m-vinylbenzyl methyl ether, p-vinylbenzyl methyl ether, o-vinylbenzyl glycidyl ether, m-vinylbenzyl glycidyl ether and p-vinylbenzyl glycidyl ether;
indenes such as indene and 1-methylindene;

unsaturated carboxylates such as methyl (meth)acrylate, ethyl (meth)acrylate, n-propyl (meth)acrylate, i-propyl (meth)acrylate, n-butyl (meth)acrylate, i-butyl (meth)acrylate, sec-butyl (meth)acrylate, t-butyl (meth)acrylate, 2-ethylhexyl (meth)acrylate, 2-hydroxyethyl (meth)acrylate, 2-hydroxypropyl (meth)acrylate, 3-hydroxypropyl (meth)acrylate, 2-hydroxybutyl (meth)acrylate, 3-hydroxybutyl (meth)acrylate, 4-hydroxybutyl (meth)acrylate, allyl (meth)acrylate, benzyl (meth)acrylate, cyclohexyl (meth)acrylate, phenyl (meth)acrylate, 2-methoxyethyl (meth)acrylate, 2-phenoxyethyl (meth)acrylate, methoxydiethyleneglycol (meth)acrylate, methoxytriethyleneglycol (meth)acrylate, methoxypropyleneglycol (meth)acrylate, methoxydipropyleneglycol (meth)acrylate, isobornyl (meth) acrylate, tricyclo[5.2.1.0^{2,6}]decane-8-yl (meth)acrylate, 2-hydroxy-3-phenoxypropyl (meth)acrylate, glycerol mono(meth)acrylate and 4-hydroxyphenyl (meth)acrylate;

unsaturated carboxylic acid aminoalkyl esters such as 2-aminoethyl (meth)acrylate, 2-dimethylaminoethyl (meth)acrylate, 2-aminopropyl (meth)acrylate, 2-dimethylaminopropyl (meth)acrylate, 3-aminopropyl (meth)acrylate and 3-dimethylaminopropyl (meth)acrylate;
unsaturated carboxylic acid glycidyl esters such as glycidyl (meth)acrylate;
vinyl carboxylates such as vinyl acetate, vinyl propionate, vinyl butyrate and vinyl benzoate;
other unsaturated ethers such as vinyl methyl ether, vinyl ethyl ether and allyl glycidyl ether;
cyanated vinyl compounds such as (meth)acrylonitrile, α-chloroacrylonitrile and vinylidene cyanide;
unsaturated amides such as (meth)acrylamide, α-chloroacrylamide and N-2-hydroxyethyl(meth)acrylamide;
aliphatic conjugated dienes such as 1,3-butadiene isoprene and chloroprene; and
macromonomers having a mono(meth)acryloyl group on the terminal of the polymer molecular chain, such as polystyrene, polymethyl (meth)acrylate, poly-n-butyl (meth)acrylate and polysiloxane.
These copolymerizable unsaturated monomers may be used singly or as a mixture of two or more.

The carboxyl group-containing copolymer in the present invention is preferably a copolymer (hereinafter, referred to as "carboxyl group-containing copolymer (C1)") of (c1) a carboxyl group-containing unsaturated monomer(s) including (meth)acrylic acid as an essential component and as the case may be, including mono[2-(meth)acryloyloxyethyl] succinate and/or ω-carboxypolycaprolactone mono(meth)acrylate, (c2) an N-substituted maleimide, and (c3) at least one other copolymerizable unsaturated monomer selected from the group consisting of styrene, α-methylstyrene, p-hydroxy-α-methylstyrene, methyl (meth)acrylate, n-butyl (meth)acrylate, 2-ethylhexyl (meth)acrylate, 2-hydroxyethyl (meth)acrylate, allyl (meth)acrylate, benzyl (meth)acrylate, glycerol mono(meth)acrylate, a polystyrene macromonomer and a polymethyl methacrylate macromonomer.

Preferable specific examples of the carboxyl group-containing copolymer (C1) include
(meth)acrylic acid/N-phenylmaleimide/styrene/benzyl (meth)acrylate copolymers,
(meth)acrylic acid/N-m-hydroxyphenylmaleimide/styrene/benzyl (meth)acrylate copolymers,
(meth)acrylic acid/N-p-hydroxyphenylmaleimide/styrene/benzyl (meth)acrylate copolymers,
(meth)acrylic acid/N-cyclohexylmaleimide/styrene/benzyl (meth)acrylate copolymers,
(meth)acrylic acid/N-phenylmaleimide/α-methylstyrene/benzyl (meth)acrylate copolymers,
(meth)acrylic acid/N-phenylmaleimide/styrene/n-butyl (meth)acrylate copolymers,
(meth)acrylic acid/N-phenylmaleimide/styrene/2-ethylhexyl (meth)acrylate copolymers,
(meth)acrylic acid/N-phenylmaleimide/p-hydroxy-α-methylstyrene/benzyl (meth)acrylate copolymers,
(meth)acrylic acid/N-phenylmaleimide/styrene/n-butyl (meth)acrylate copolymers,
(meth)acrylic acid/N-phenylmaleimide/styrene/2-ethylhexyl (meth)acrylate/2-hydroxyethyl (meth)acrylate/benzyl (meth)acrylate copolymers,
(meth)acrylic acid /N-phenylmaleimide/styrene/2-hydroxyethyl(meth)acrylate/benzyl (meth)acrylate copolymers,
(meth)acrylic acid/N-phenylmaleimide/styrene/benzyl (meth)acrylate/glycerol mono(meth)acrylate copolymers,
(meth)acrylic acid/N-p-hydroxyphenylmaleimide/styrene/benzyl (meth)acrylate/glycerol mono(meth)acrylate copolymers,
(meth)acrylic acid/N-phenylmaleimide/styrene/phenyl (meth)acrylate/2-hydroxyethyl (meth)acrylate/polystyrene macromonomer copolymers,
(meth)acrylic acid/N-phenylmaleimide/styrene/phenyl (meth)acrylate/2-hydroxyethyl (meth)acrylate/polymethyl methacrylate macromonomer copolymers,
(meth)acrylic acid/mono[2-(meth)acryloyloxyethyl] succinate/N-phenylmaleimide/styrene/benzyl (meth)acrylate copolymers,
(meth)acrylic acid/mono[2-(meth)acryloyloxyethyl] succinate/N-p-hydroxyphenylmaleimide/styrene/benzyl (meth)acrylate copolymers,
(meth)acrylic acid/mono[2-(meth)acryloyloxyethyl] succinate/N-phenylmaleimide/styrene/allyl (meth)acrylate copolymers,
(meth)acrylic acid/mono[2-(meth)acryloyloxyethyl] succinate/N-cyclohexylmaleimide/styrene/allyl (meth)acrylate copolymers,
(meth)acrylic acid/mono[2-(meth)acryloyloxyethyl] succinate/N-cyclohexylmaleimide/styrene/benzyl (meth)acrylate copolymers,
(meth)acrylic acid/ω-carboxypolycaprolactone mono(meth)acrylate/N-m-hydroxyphenylmaleimide/styrene/benzyl (meth)acrylate copolymers,
(meth)acrylic acid/ω-carboxypolycaprolactone mono(meth)acrylate/N-p-hydroxyphenylmaleimide/styrene/benzyl (meth)acrylate copolymers,
(meth)acrylic acid/ω-carboxypolycaprolactone mono(meth)acrylate/N-phenylmaleimide/styrene/benzyl (meth)acrylate/glycerol mono(meth)acrylate copolymers, and
(meth)acrylic acid/ω-carboxypolycaprolactone mono(meth)acrylate/N-p-hydroxyphenylmaleimide/styrene/benzyl (meth)acrylate/glycerol mono(meth)acrylate copolymers.

Carboxyl group-containing copolymers other than the carboxyl group-containing copolymer (C1) include, for example,
(meth)acrylic acid/methyl (meth)acrylate copolymers,
(meth)acrylic acid/benzyl (meth)acrylate copolymers,
(meth)acrylic acid/2-hydroxyethyl (meth)acrylate/benzyl (meth)acrylate copolymers,
(meth)acrylic acid/methyl (meth)acrylate/polystyrene macromonomer copolymers,
(meth)acrylic acid/methyl (meth)acrylate/polymethyl methacrylate macromonomer copolymers,
(meth)acrylic acid/benzyl (meth)acrylate/polystyrene macromonomer copolymers,
(meth)acrylic acid/benzyl (meth)acrylate/polymethyl methacrylate macromonomer copolymers,
(meth)acrylic acid/2-hydroxyethyl (meth)acrylate/benzyl (meth)acrylate/polystyrene macromonomer copolymers, and
(meth)acrylic acid/2-hydroxyethyl (meth)acrylate/benzyl (meth)acrylate/polymethyl methacrylate macromonomer copolymers.

In the carboxyl group-containing copolymer, the copolymerization ratio of the carboxyl group-containing unsaturated monomer is preferably 5 to 50% by weight, more preferably 10 to 40% by weight. In this case, with the copolymerization ratio of less than 5% by weight, the solubility of the obtained radiation-sensitive composition to an alkali liquid developer is likely to decrease; by contrast, with that exceeding 50% by weight, the solubility to an alkali liquid developer becomes excessively large, whereby on development with the alkali liquid developer, the composition is likely to cause falling-off from a pixel substrate and film chapping of the pixel surface.

Mw of the alkali-soluble resin measured by gel permeation chromatography (GPC, elution solvent: tetrahydrofuran) is preferably 3,000 to 300,000, more preferably 5,000 to 100,000.
Mn of the alkali-soluble resin measured by gel permeation chromatography (GPC, elution solvent: tetrahydrofuran) is preferably 3,000 to 60,000, more preferably 5,000 to 25,000.
The ratio of Mw to Mn (Mw/Mn) of the alkali-soluble resin is preferably 1 to 5, more preferably 1 to 4.

In the present invention, use of an alkali-soluble resin having such specific Mw and Mn can provide a radiation-sensitive composition excellent in developability, whereby pixel patterns having a sharp pattern edge can be formed and residues, scumming, film remaining and the like on unexposed parts of a substrate and a light shielding layer are hardly generated.
In the present invention, the alkali-soluble resins may be used singly or as a mixture of two or more.

The content of the alkali-soluble resin in the present invention is preferably 10 to 1,000 parts by weight, more preferably 20 to 500 parts by weight, with respect to 100 parts by weight of (A) the pigment. In this case, with the content of the alkali-soluble resin of less than 10 parts by weight, for example, the alkali developability may decrease and scumming and film remaining on unexposed parts of a substrate and a light shielding layer may be generated; by contrast, with that exceeding 1,000 parts by weight, since the pigment concentration relatively decreases, achievement of a target color density as a thin film may become difficult.

(D) The polyfunctional monomer in the present invention is a monomer having at least two polymerizable unsaturated bonds.
The polyfunctional monomers include, for example:
di(meth)acrylates of alkylene glycols such as ethylene glycol and propylene glycol;
di(meth)acrylates of polyalkylene glycols such as polyethylene glycol and polypropylene glycol;
poly(meth)acrylates of tri- or more polyhydric alcohols, such as glycerol, trimethylolpropane, pentaerythritol and dipentaerythritol, and their dicarboxylic acid-modified compounds;
oligo(meth)acrylates such as polyester, epoxy resins, urethane resins, alkyd resins, silicone resins and spirane resins; and
di(meth)acrylates of both-end hydroxylated polymers such as both-end hydroxylated poly-1,3-butadiene, both-end hydroxylated polyisoprene and both-end hydroxylated polycaprolactone, and tris[2-(meth)acryloyloxyethyl]phosphate.

Among these polyfunctional monomers, poly(meth)acrylates of tri- or more polyhydric alcohols and their dicarboxylic acid-modified compounds, specifically, trimethylolpropane tri(meth)acrylate, pentaerythritol tri(meth)acrylate, pentaerythritol tetra(meth)acrylate, dipentaerythritol penta(meth)acrylate dipentaerythritol hexa(meth)acrylate and the like are preferable; especially, trimethylolpropane triacrylate, pentaerythritol triacrylate and dipentaerythritol hexaacrylate are preferable in that the strength and surface smoothness of pixels are excellent and in that scumming and film remaining on unexposed parts of a substrate and a light shielding layer are hardly generated.
The polyfunctional monomers may be used singly or as a mixture of two or more.

The content of (D) the polyfunctional monomer in the present invention is preferably 5 to 500 parts by weight, more preferably 20 to 300 parts by weight, with respect to 100 parts by weight of (C) the alkali-soluble resin. In this case, with the content of the polyfunctional monomer of less than 5 parts by weight, the strength and surface smoothness of pixels are likely to decrease; by contrast, with that exceeding 500 parts by weight, for example, the alkali developability is likely to decrease and scumming, film remaining and the like on unexposed parts of a substrate and a light shielding layer are likely to be easily generated.

In the present invention, a part of the polyfunctional monomer may be replaced by a monofunctional monomer having one polymerizable unsaturated bond.
The monofunctional monomers include, for example, a monomer similar to the carboxyl group-containing unsaturated monomer and the copolymerizable unsaturated monomer exemplified for (C) the alkali-soluble resin, N-(meth)acryloylmorpholine, N-vinylpyrrolidone, N-vinyl-s-caprolactam, and besides, M-5600 (trade name, made by Toagosei Co., Ltd.).
These monofunctional monomers may be used singly or as a mixture of two or more.

The content ratio of the monofunctional monomer in the present invention is preferably not more than 90% by weight, more preferably not more than 50% by weight with respect to the total amount of the polyfunctional monomer and the monofunctional monomer. In this case, with the use amount of the monofunctional monomer exceeding 90% by weight, the strength and surface smoothness of pixels may become insufficient.
The total content of the polyfunctional monomer and the monofunctional monomer in the present invention is preferably 5 to 500 parts by weight, more preferably 20 to 300 parts by weight, with respect to 100 parts by weight of (C) the alkali-soluble resin. In this case, with the total content of less than 5 parts by weight, the strength and surface smoothness of pixels are likely to decrease; by contrast, with that exceeding 500 parts by weight, for example, the alkali developability is likely to decrease and scumming, film remaining and the like on unexposed parts of a substrate and a light shielding layer are likely to be easily generated.

(E) the photopolymerization initiator in the present invention is a compound which generates an active species capable of initiating polymerization of (D) the polyfunctional monomer and the monofunctional monomer used as the case may be, by exposure to a radiation such as visible light, ultraviolet light, far ultraviolet light, electron beams or X-rays.
Such photopolymerization initiators include, for example, acetophenone compounds, biimidazole compounds, triazine compounds, O-acyloxime compounds, thioxanthone compounds, ketocoumarin compounds, onium salt compounds, benzoin compounds, benzophenone compounds, α-diketone compounds, polynuclear quinone compounds, xanthone compounds, diazo compounds and imidesulfonate compounds. These compounds are components generating an active radical or an active acid, or both thereof by exposure.

In the present invention, the photopolymerization initiators may be used singly or as a mixture of two or more, but a photopolymerization initiator in the present invention is preferably one selected from the group consisting of acetophenone compounds, biimidazole compounds, triazine compounds, O-acyloxime compounds, thioxanthone compounds and ketocoumarin compounds.

In the present invention, the content of the photopolymerization initiator is commonly 0.01 to 120 parts by weight, preferably 1 to 100 parts by weight, with respect to 100 parts by weight of the total of (D) the polyfunctional monomer and the monofunctional monomer. In this case, with the content of the photopolymerization initiator of less than 0.01 part by weight, curing by exposure becomes insufficient, whereby it may be difficult to obtain a color filter in which colored layer patterns are arranged according to a predetermined arrangement; by contrast, with that exceeding 120 parts by weight, the obtained colored layer is likely to fall off a substrate on development.

Specific examples of the acetophenone compounds among the preferable photopolymerization initiators in the present invention include 2-hydroxy-2-methyl-1-phenylpropan-1-one, 2-methyl-1-[4-(methylthio)phenyl]-2-morpholinopropan-1-one, 2-benzyl-2-dimethylamino-1-(4-morpholinophenyl)butan-1-one, 1-hydroxycyclohexyl phenyl ketone, 2,2-dimethoxy-1,2-diphenylethan-1-one and 1,2-octanedione.
Among these acetophenone compounds, especially preferable are 2-methyl-1-[4-(methylthio)phenyl]-2-morpholinopropan-1-one, 2-benzyl-2-dimethylamino-1-(4-morpholinophenyl)butan-1-one, 1,2-octanedione and the like.
The acetophenone compounds may be used singly or as a mixture of two or more.

In the present invention, the content of the acetophenone compound in the case of using it as a photopolymerization initiator is commonly 0.01 to 80 parts by weight, preferably 1 to 70 parts by weight, more preferably 1 to 60 parts by weight, with respect to 100 parts by weight of the total of (D) the polyfunctional monomer and the monofunctional monomer. In this case, with the content of the acetophenone compound of less than 0.01 part by weight, curing by exposure becomes insufficient, whereby it may be difficult to obtain a color filter in which colored layer patterns are arranged according to a predetermined arrangement; by contrast, with that exceeding 80 parts by weight, the formed colored layer is likely to fall off a substrate on development.

Specific examples of the biimidazole compounds include 2,2'-bis(2-chlorophenyl)-4,4',5,5'-tetrakis(4-ethoxycarbonylphenyl)-1,2'-biimidazole, 2,2'-bis(2-bromophenyl)-4,4',5,5'-tetrakis(4-ethoxycarbonylphenyl)-1,2'-biimidazole, 2,2'-bis(2-chlorophenyl)-4,4',5,5'-tetraphenyl-1,2'-biimidazole, 2,2'-bis(2,4-dichlorophenyl)-4,4',5,5'-tetraphenyl-1,2'-biimidazole, 2,2'-bis(2,4,6-trichlorophenyl)-4,4',5,5'-tetraphenyl-1,2'-biimidazole, 2,2'-bis(2-bromophenyl)-4,4',5,5'-tetraphenyl-1,2'-biimidazole, 2,2'-bis(2,4-dibromophenyl)-4,4',5,5'-tetraphenyl-1,2'-biimidazole and 2,2'-bis(2,4,6-tribromophenyl)-4,4',5,5'-tetraphenyl-1,2'-biimidazole.

Among these biimidazole compounds, preferable are 2,2'-bis(2-chlorophenyl)-4,4',5,5'-tetraphenyl-1,2'-biimidazole, 2,2'-bis(2,4-dichlorophenyl)-4,4',5,5'-tetraphenyl-1,2'-biimidazole and 2,2'-bis(2,4,6-trichlorophenyl)-4,4',5,5'-tetraphenyl-1,2'-biimidazole, and especially, 2,2'-bis(2-chlorophenyl)-4,4',5,5'-tetraphenyl-1,2'-biimidazole.
Since these biimidazole compounds are excellent in solubility to a solvent, generating no foreign matters such as undissolved substances and deposited substances, and have a high sensitivity, progressing fully the curing reaction by exposure of a small amount of energy and generating no curing reaction in unexposed parts, the coated film after exposure is clearly divided into cured parts insoluble to a liquid developer and uncured parts having a high solubility to the liquid developer, whereby a high-precision color filter can be formed in which colored layer patterns exhibiting no undercut are arranged according to a predetermined arrangement.
The biimidazole compounds may be used singly or as a mixture of two or more.

In the present invention, the content of the biimidazole compound in the case of using it as a photopolymerization initiator is commonly 0.01 to 40 parts by weight, preferably 1 to 30 parts by weight, more preferably 1 to 20 parts by weight, with respect to 100 parts by weight of the total of (D) the polyfunctional monomer and a monofunctional monomer. In this case, with the content of the biimidazole compound of less than 0.01 part by weight, curing by exposure becomes insufficient, whereby it may be difficult to obtain a color filter in which colored layer patterns are arranged according to a predetermined arrangement; by contrast, with that exceeding 40 parts by weight, falling-off from a substrate of the formed colored layer and film chapping of the colored layer surface are likely to easily occur on development.

In the present invention, when the biimidazole compound is used as a photopolymerization initiator, a hydrogen donor described below is preferably used concurrently in view of the sensitivity being further improved.
The "hydrogen donor" mentioned here means a compound which can donate a hydrogen atom to a radical generated from a biimidazole compound by exposure.
The hydrogen donor in the present invention is preferably a mercaptan compound, an amine compound and the like described below.

The mercaptan compound (hereinafter, referred to as "mercaptan hydrogen-donor") is a compound having a benzene ring or a heterocycle as a mother nucleus and having at least one, preferably 1 to 3, more preferably 1 or 2 mercapto groups bonding directly to the mother nucleus.
The amine compound (hereinafter, referred to as "amine hydrogen-donor") is a compound having a benzene ring or a heterocycle as a mother nucleus and having at least one, preferably 1 to 3, more preferably 1 or 2 amino groups bonding directly to the mother nucleus.
These hydrogen donors may concurrently have a mercapto group and an amino group.

Hereinafter, the hydrogen donor will be described more specifically.
The mercaptan hydrogen-donor can have at least one benzene ring or heterocycle each, and can have both of a benzene ring and a heterocycle; when the mercaptan hydrogen-donor has two or more these rings, it may or may not form a condensed ring.
When the mercaptan hydrogen-donor has two or more mercapto groups, as long as it has at least one free mercapto group remaining, it may have the other mercapto groups substituted with one or more alkyl, aralkyl or aryl groups; further, as long as it has at least one free mercapto group remaining, it may have a structural unit in which two sulfur atoms are bonded through a divalent organic group such as an alkylene group, or a structural unit in which two sulfur atoms are bonded in the disulfide form.
Further, the mercaptan hydrogen-donor may be substituted, at positions other than a mercapto group, with a carboxyl group, an alkoxycarbonyl group, a substituted alkoxycarbonyl group, a phenoxycarbonyl group, a substituted phenoxycarbonyl group, a nitrile group and the like.

Specific examples of such a mercaptan hydrogen donor include 2-mercaptobenzothiazole, 2-mercaptobenzooxazol, 2-mercaptobenzimidazole, 2,5-dimercapto-1,3,4-thiadiazole and 2-mercapto-2,5-dimethylaminopyridine.
Among these mercaptan hydrogen-donors, preferable are 2-mercaptobenzothiazole and 2-mercaptobenzooxazole, and especially, 2-mercaptobenzothiazole.

The amine hydrogen-donor can have at least one benzene ring or heterocycle each, and can have both of a benzene ring and a heterocycle; when the amine hydrogen-donor has two or more these rings, it may or may not form a condensed ring.
Further, the amine hydrogen-donor may have one or more amino groups substituted with an alkyl group or a substituted alkyl group, and may be substituted, at positions other than an amino group, with a carboxyl group, an alkoxycarbonyl group, a substituted alkoxycarbonyl group, a phenoxycarbonyl group, a substituted phenoxycarbonyl group, a nitrile group and the like.

Specific examples of such amine hydrogen-donors include 4,4'-bis(dimethylamino)benzophenone, 4,4'-bis(diethylamino)benzophenone, 4-diethylaminoacetophenone, 4-dimethylaminopropiophenone, ethyl-4-dimethylaminobenzoate, 4-dimethylaminobenzoic acid and 4-dimethylamino benzonitrile.
Among these amine hydrogen-donors, preferable are 4,4'-bis(dimethylamino)benzophenone and 4,4'-bis(diethylamino)benzophenone, and especially, 4,4'-bis(diethylamino)benzophenone.
Then, the amine hydrogen-donors have an action as a sensitizer even in the case of radical generating agents other than biimidazole compounds.

In the present invention, the hydrogen donors may be used singly or as a mixture of two or more, but use in combination of one or more mercaptan hydrogen-donors and one or more amine hydrogen-donors is preferable in that the formed colored layer hardly falls off a substrate on development, and the colored layer has a high strength and sensitivity.
Specific examples of the combinations of the mercaptan hydrogen-donor and the amine hydrogen-donor include 2-mercaptobenzothiazole/4,4'-bis(dimethylamino)benzophenone, 2-mercaptobenzothiazole/4,4'-bis(diethylamino)benzophenone, 2-mercaptobenzooxazol/4,4'-bis(dimethylamino)benzophenone and 2-mercaptobenzooxazol/4,4'-bis(diethylamino)benzophenone; more preferable combinations are 2-mercaptobenzothiazole/4,4'-bis(diethylamino)benzophenone and 2-mercaptobenzooxazol/4,4'-bis(diethylamino)benzophenone; an especially preferable combination is 2-mercaptobenzothiazole/4,4'-bis(diethylamino)benzophenone.
The weight ratio of the mercaptan hydrogen-donor and the amine hydrogen-donor in combinations thereof is commonly 1:1 to 1:4, preferably 1:1 to 1:3.

In the present invention, the content of the hydrogen donor in the case of using the hydrogen donor concurrently with the biimidazole compound is preferably 0.01 to 40 parts by weight, more preferably 1 to 30 parts by weight, especially preferably 1 to 20 parts by weight, with respect to 100 parts by weight of the total of (D) the polyfunctional monomer and the monofunctional monomer. In this case, with the content of the hydrogen donor of less than 0.01 part by weight, the improvement effect of the sensitivity is likely to decrease; by contrast, with that exceeding 40 parts by weight, the formed colored layer is likely to easily fall off a substrate on development.

Specific examples of the triazine compounds include triazine compounds having a halomethyl group, such as 2,4,6-tris(trichloromethyl)-s-triazine, 2-methyl-4,6-bis(trichloromethyl)-s-triazine, 2-[2-(5-methylfuran-2-yl)ethenyl]-4,6-bis(trichloromethyl)-s-triazine, 2-[2-(furan-2-yl)ethenyl]-4,6-bis(trichloromethyl)-s-triazine, 2-[2-(4-diethylamino-2-methylphenyl)ethenyl]-4,6-bis(trichloromethyl)-s-triazine, 2-[2-(3,4-dimethoxyphenyl)ethenyl]-4,6-bis(trichloromethyl)-s-triazine, 2-(4-methoxypheny)-4,6-bis(trichloromethyl)-s-triazine, 2-(4-ethoxystyryl)-4,6-bis(trichloromethyl)-s-triazine and 2-(4-n-butoxyphenyl)-4,6-bis(trichloromethyl)-s-triazine.

Among these triazine compounds, especially preferable is 2-[2-(3,4-dimethoxyphenyl)ethenyl]-4,6-bis(trichloromethyl)-s-triazine.
The triazine compounds may be used singly or as a mixture of two or more.

In the present invention, the content of the triazine compound in the case of using it as a photopolymerization initiator is preferably 0.01 to 40 parts by weight, more preferably 1 to 30 parts by weight, especially preferably 1 to 20 parts by weight, with respect to 100 parts by weight of the total of (D) the polyfunctional monomer and the monofunctional monomer.
In this case, with the content of the triazine compound of less than 0.01 part by weight, curing by exposure becomes insufficient, whereby it may be difficult to obtain a color filter in which colored layer patterns are arranged according to a predetermined arrangement; by contrast, with that exceeding 40 parts by weight, the formed colored layer is likely to easily fall off a substrate on development.

Specific examples of the O-acyloxime compounds include 1-[4-(phenylthio)phenyl]-heptane-1,2-dione 2-(0-benzoyloxime), 1-[4-(phenylthio)phenyl]-octane-1,2-dione 2-(O-benzoyloxime), 1-[4-(benzoyl)phenyl]-octane-1,2-dione 2-(O-benzoyloxime), 1-[9-ethyl-6-(2-methylbenzoyl)-9H-carbazole-3-yl]-ethanone 1-(O-acetyloxime), 1-[9-ethyl-6-(3-methylbenzoyl)-9H-carbazole-3-yl]-ethanone 1-(O-acetyloxime), 1-(9-ethyl-6-benzoyl-9H-carbazole-3-yl)-ethanone 1-(O-acetyloxime), ethanone-1-[9-ethyl-6-(2-methyl-4-tetrahydrofuranylbenzoyl)-9.H.-carbazole-3-yl]-1-(O-acetyloxime), ethanone-1-[9-ethyl-6-(2-methyl-4-tetrahydropyranylbenzoyl)-9.H.-carbazole-3-yl]-1-(O-acetyloxime), ethanone-1-[9-ethyl-6-(2-methyl-5-tetrahydrofuranylbenzoyl)-9.H.-carbazole-3-yl]-1-(O-acetyloxime), ethanone-1-[9-ethyl-6-(2-methyl-5-tetrahydropyranylbenzoyl)-9.H.-carbazole-3-yl]-1-(O-acetyloxime), ethanone-1-[9-ethyl-6-{2-methyl-4-(2,2-dimethyl-1,3-dioxolanyl)benzoyl}-9.H.-carbazole-3-yl]-1-(O-acetyloxime), ethanone-1-[9-ethyl-6-(2-methyl-4-tetrahydrofuranylmethoxybenzoyl)-9.H.-carbazole-3-yl]-1-(O-acetyloxime), ethanone-1-[9-ethyl-6-(2-methyl-4-tetrahydropyranylmethoxybenzoyl)-9.H.-carbazole-3-yl]-1-(O-acetyloxime), ethanone-1-[9-ethyl-6-(2-methyl-5-tetrahydrofuranylmethoxybenzoyl)-9.H.-carbazole-3-yl]-1-(O-acetyloxime), ethanone-1-[9-ethyl-6-(2-methyl-5-tetrahydropyranylmethoxybenzoyl)-9.H.-carbazole-3-yl]-1-(O-acetyloxime), ethanone-1-[9-ethyl-6-{2-methyl-4-(2,2-dimethyl-1,3-dioxolanyl)methoxybenzoyl}-9.H.-carbazole-3-yl]-1-(O-acetyloxime) and the like.

Among these O-acyloxime compounds, especially preferable are 1-[4-(phenylthio)phenyl]-octane-1,2-dione 2-(O-benzoyloxime), 1-[9-ethyl-6-(2-methylbenzoyl)-9H-carbazole-3-yl]-ethanone 1-(O-acetyloxime), ethanone-1-[9-ethyl-6-(2-methyl-4-tetrahydrofuranylmethoxybenzoyl)-9.H.-carbazole-3-yl]-1-(O-acetyloxime), ethanone-1-[9-ethyl-6-{2-methyl-4-(2,2-dimethyl-1,3-dioxolanyl)methoxybenzoyl}-9.H.-carbazole-3-yl]-1-(O-acetyloxime) and the like.
The O-acyloxime compounds may be used singly or as a mixture of two or more.

In the present invention, the content of the O-acyloxime compound in the case of using it as a photopolymerization initiator is preferably 0.01 to 80 parts by weight, more preferably 1 to 70 parts by weight, especially preferably 1 to 60 parts by weight, with respect to 100 parts by weight of the total of (D) the polyfunctional monomer and the monofunctional monomer. In this case, with the content of the O-acyloxime compound of less than 0.01 part by weight, curing by exposure becomes insufficient, whereby it may be difficult to obtain a color filter in which colored layer patterns are arranged according to a predetermined arrangement; by contrast, with that exceeding 80 parts by weight, the formed colored layer is likely to easily fall off a substrate on development.

Specific examples of the thioxanthone compounds include thioxanthone, 2-chlorothioxanthone, 2,4-diethylthioxanthone, 2-methylthioxanthone and 2-i-propylthioxanthone.
Among these thioxanthone compounds, especially preferably is 2,4-diethylthioxanthone.
The thioxanthone compounds may be used singly or as a mixture of two or more.

In the present invention, the content of the thioxanthone compound in the case of using it as a photopolymerization initiator is preferably 0.01 to 60 parts by weight, more preferably 1 to 55 parts by weight, especially preferably 1 to 50 parts by weight, with respect to 100 parts by weight of the total of (D) the polyfunctional monomer and the monofunctional monomer. In this case, with the content of the thioxanthone compound of less than 0.01 part by weight, curing by exposure becomes insufficient, whereby it may be difficult to obtain a color filter in which colored layer patterns are arranged according to a predetermined arrangement; by contrast, with that exceeding 60 parts by weight, the formed colored layer is likely to easily fall off a substrate on development.

The ketocoumalin compounds include, for example, 3-ketocoumalin.
In the present invention, the content of the ketocoumalin compound in the case of using it as a photopolymerization initiator is preferably 0.01 to 60 parts by weight, more preferably 1 to 55 parts by weight, especially preferably 1 to 50 parts by weight, with respect to 100 parts by weight of the total of (D) the polyfunctional monomer and the monofunctional monomer. In this case, with the content of the ketocoumalin compound of less than 0.01 part by weight, curing by exposure becomes insufficient, whereby it may be difficult to obtain a color filter in which colored layer patterns are arranged according to a predetermined arrangement; by contrast, with that exceeding 60 parts by weight, the formed colored layer is likely to easily fall off a substrate on development.

The (F) component in the present invention is a compound represented by the formula (1) described before, and is a compound (hereinafter, also referred to as "polymerization inhibitor (F)") which can inhibit the polymerization, initiated by the (E) component described above along with exposure to radiation such as visible light, ultraviolet light, far ultraviolet light, electron beams and X-rays, of (D) the polyfunctional monomer, and the monofunctional monomer used as the case may be.

In the formula (1), the halogen atoms denoted by R¹ to R⁸ include a fluorine atom, a chlorine atom, a bromine atom and an iodine atom. The monovalent organic groups include an alkyl group, an alkenyl group, an alkoxy group, an alkenyloxy group, a cyano group, an amino group, a nitro group and a halogenoalkyl group. Among these, an alkyl group, an alkoxy group and a cyano group are preferable. Specific examples of the alkyl groups include linear or branched alkyl groups having 1 to 8 carbon atoms, such as a methyl group, an ethyl group, an isopropyl group, n-butyl group and n-pentyl group. Specific examples of the alkoxy groups include linear or branched alkoxy groups having 1 to 8 carbon atoms, such as a methoxy group, an ethoxy group, an isopropoxy group, an n-butoxy group and n-pentyl group.

Specific examples of the polymerization inhibitors (F) include phenothiazine, 2-methoxyphenothizaine, 3-methoxyphenothiazine, 2-chlorophenothiazine and 2-cyanophenothiazine. Among these polymerization inhibitors (F), phenothiazine is preferable.
The polymerization inhibitors (F) may be used singly or as a mixture of two or more.

In this invention, another polymerization inhibitor can be used concurrently with the polymerization inhibitor (F). The another polymerization inhibitor includes 4-methoxyphenol, t-butylhydroquinone, p-t-butylcatechol, 4-methoxy-1-naphthol and triphenylphosphine.
These polymerization inhibitors may be used singly or as a mixture of two or more.

The content ratio of the another polymerization inhibitor is preferably 0 to 75% by weight, more preferably 0 to 50% by weight with respect to the total amount of the polymerization inhibitor (F) and the another polymerization inhibitor. In this case, with the content ratio of the another polymerization inhibitor exceeding 75% by weight, a sufficient resolution may not be secured.
The content of the polymerization inhibitor (F) in the present invention is preferably 0.1 to 10 parts by weight, more preferably 0.1 to 7.5 parts by weight, with respect to 100 parts by weight of the photopolymerization initiator (E). In this case, with the content of the polymerization inhibitor (F) of less than 0.1 part by weight, a sufficient resolution may not be secured; by contrast, with that exceeding 10 parts by weight, the adhesiveness and the surface smoothness of pixels are likely to decrease and the film reduction on development is likely to increase.

The radiation-sensitive composition in the present invention may contain various types of additive components as required.
The additive components include organic acids or organic amino compounds (here, excluding the above-mentioned hydrogen donors) which further improve the solubility characteristic of a radiation-sensitive composition to an alkali liquid developer, and exhibit the action to suppress remaining of undissolved substances after development.

The organic acid is preferably an aliphatic carboxylic acid or a phenyl group-containing carboxylic acid having at least one carboxyl group in their molecule.
The aliphatic carboxylic acids include, for example,
aliphatic monocarboxylic acids such as formic acid, acetic acid, propionic acid, butyric acid, valeric acid, pivalic acid, caproic acid, diethylacetic acid, enanthic acid and caprylic acid;
aliphatic dicarboxylic acids such as oxalic acid, malonic acid, succinic acid, glutaric acid, adipic acid, pimelic acid, suberic acid, azelaic acid, sebacic acid, brasylic acid, methylmalonic acid, ethylmalonic acid, dimethylmalonic acid, methylsuccinic acid, tetramethylsuccinic acid, cyclohexanedicarboxylic acid, itaconic acid, citraconic acid, maleic acid, fumaric acid and mesaconic acid; and
aliphatic tricarboxylic acids such as tricarballylic acid, aconitic acid and camphoronic acid.

The phenyl group-containing carboxylic acids include, for example, a compound in which a carboxyl group is directly bonded to a phenyl group, and a compound in which a carboxyl group is bonded to a phenyl group through a divalent carbon chain.
The phenyl group-containing carboxylic acids include, for example:
aromatic monocarboxylic acids such as benzoic acid, toluic acid, cumic acid, hemelitic acid and mesitylene acid;
aromatic dicarboxylic acids such as phthalic acid and isophthalic acid and terephthalic acid;
tri- or more valent aromatic polycarboxylic acids such as trimellitic acid, trimesic acid, mellophanic acid and pyromellitic acid; and
phenylacetic acid, hydratropic acid, hydrocinnamic acid, mandelic acid, phenylsuccinic acid, atropic acid, cinnamic acid, cinnamylidenic acid, coumaric acid and umbellic acid.

Among these organic acids, in view of the alkali solubility, the solubility to a solvent described later, and the prevention of scumming and film remaining on unexposed parts of a substrate and a light shielding layer, aliphatic carboxylic acids are preferably aliphatic dicarboxylic acids, especially preferably malonic acid, adipic acid, itaconic acid, citraconic acid, fumaric acid and mesaconic acid; and phenyl group-containing carboxylic acids are preferably aromatic dicarboxylic acids, especially preferably phthalic acid.
The organic acids may be used singly or as a mixture of two or more.
The content of the organic acid is preferably not more than 15 parts by weight, more preferably not more than 10 parts by weight, with respect to 100 parts by weight of the total of the (A) to (E) components and the additive components. In this case, with the content of the organic acid exceeding 15 parts by weight, the adhesiveness of the formed pixels to a substrate is likely to decrease.

The organic amino compounds are preferably aliphatic amines or phenyl group-containing amines having at least one amino group in their molecule.
The aliphatic amines include, for example:
mono(cyclo)alkylamines such as n-propylamine, i-propylamine, n-butylamine, i-butylamine, sec-butylamine, tert-butylamine, n-pentylamine and n-hexylamine;
di(cyclo)alkylamines such as methylethylamine, diethylamine, methyl-n-propylamine, ethyl-n-propylamine, di-n-propylamine, di-i-propylamine, di-n-butylamine, di-i-butylamine, di-sec-butylamine and di-tert-butylamine;

tri(cyclo)alkylamines such as dimethylethylamine, methyldiethylamine, triethylamine, dimethyl-n-propylamine, diethyl-n-propylamine, methyldi-n-propylamine, ethyldi-n-propylamine, tri-n-propylamine, tri-i-propylamine, tri-n-butylamine, tri-i-butylamine, tri-sec-butylamine and tri-t-butylamine;
mono(cyclo)alkanolamines such as 2-aminoethanol, 3-amino-1-propanol, 1-amino-2-propanol and 4-amino-1-butanol;

di(cyclo)alkanolamines such as diethanolamine, di-n-propanolamine, di-i-propanolamine, di-n-butanolamine and di-i-butanolamine;
tri(cyclo)alkanolamines such as triethanolamine, tri-n-propanolamine, tri-i-propanolamine, tri-n-butanolamine and tri-i-butanolamine;

amino(cyclo)alkanediols such as 3-amino-1,2-propanediol, 2-amino-1,3-propanediol, 4-amino-1,2-butanediol, 4-amino-1,3-butanediol, 3-dimethylamino-1,2-propanediol, 3-diethylamino-1,2-propanediol, 2-dimethylamino-1,3-propanediol and 2-diethylamino-1,3-propanediol; and
aminocarboxylic acids such as β-alanine, 2-aminobutyric acid, 3-aminobutyric acid, 4-aminobutyric acid, 2-aminoisobutyric acid and 3-aminoisobutyric acid.

The phenyl group-containing amines include, for example, a compound in which an amino group is directly bonded to a phenyl group, and a compound in which an amino group is bonded to a phenyl group through a divalent carbon chain.
The phenyl group-containing amines include, for example:
aromatic amines such as aniline, o-methylaniline, m-methylaniline, p-methylaniline, p-ethylaniline, 1-naphthylamine, 2-naphthylamine, N,N-dimethylaniline, N,N-diethylaniline and p-methyl-N,N-dimethylaniline;
aminobenzyl alcohols such as o-aminobenzyl alcohol, m-aminobenzyl alcohol, p-aminobenzyl alcohol, p-dimethylaminobenzyl alcohol and p-diethylaminobenzyl alcohol;
aminophenols such as o-aminophenol, m-aminophenol, p-aminophenol, p-dimethylamino phenol and p-diethylaminophenol; and
aminobenzoic acids such as m-aminobenzoic acid, p-aminobenzoic acid, p-dimethylaminobenzoic acid and p-diethylaminobenzoic acid.

Among these organic amino compounds, in view of the solubility to a solvent described later, and the prevention of scumming and film remaining on unexposed parts of a substrate and a light shielding layer, aliphatic amines are preferably mono(cyclo)alkanolamines and amino(cyclo)alkanediols, especially preferably 2-aminoethanol, 3-amino-1-propanol, 5-amino-1-pentanol, 3-amino-1,2-propanediol, 2-amino-1,3-propanediol, 4-amino-1,2-butanediol and the like; and phenyl group-containing amines are preferably aminophenols, especially preferably o-aminophenol, m-aminophenol and p-aminophenol.
The organic amino compounds may be used singly or as a mixture of two or more.
The content of the organic amino compound is preferably not more than 15 parts by weight, more preferably not more than 10 parts by weight, with respect to 100 parts by weight of the total of the (A) to (E) components and the additive components. In this case, with the content of the organic amino compound exceeding 15 parts by weight, the adhesiveness of the formed pixels to a substrate is likely to decrease.

Further, additive components other than the components described above include, for example:
dispersion aids such as blue pigment derivatives like a copper phthalocyanine derivative and yellow pigment derivatives;
fillers such as glass and alumina;
polymeric compounds such as polyvinyl alcohol, polyethylene glycol monoalkyl ether and poly(fluoroalkylacrylate);
surfactants such as nonionic, cationic and anionic ones;
adhesion promoting agents such as vinyltrimetoxysilane, vinyltriethoxysilane, vinyltris(2-methoxyethoxy)silane, N-(2-aminoethyl)-3-aminopropyl methyl dimethoxysilane, N-(2-aminoethyl)-3-aminopropyltrimethoxysilane, 3-aminopropyltriethoxysilane, 3-glycidoxypropyltrimetoxysilane, 3-glycidoxypropyl methyl dimethoxysilane, 2-(3,4-epoxycyclohexyl)ethyltrimethoxysilane, 3-chloropropyl methyl dimethoxysilane, 3-chloropropyltrimetoxysilane, 3-methacryloyloxypropyltrimethoxysilane and 3-mercaptopropyltrimethoxysilane;
antioxidants such as 2,2-thiobis(4-methyl-6-t-butylphenol) and 2,6-di-t-butylphenol;
ultraviolet absorbents such as 2-(3-t-butyl-5-methyl-2-hydroxyphenyl)-5-chlorobenzotriazole and alkoxybenzophenones;
antiflocculants such as sodium polyacrylate; and
thermoradical generators such as 1,1'-azobis(cyclohexane-1-carbonitrile) and 2-phenylazo-4-methoxy-2,4-dimethylvaleronitrile. Products in trade names include surfactants, such as F top EF301, EF303 and EF352 (made by Shin Akita Kasei Co., Ltd.), Megafac F171, F172, F173, F178K, F470 (R08), F474, F475, R30, F482 and F483 (made by Dainippon Ink & Chemicals, Inc.), PF-636, PF-6320, PF-656 and PF-6520 (made by Omnova Solutions Inc.), FTX-2180 (made by Neos Co., Ltd.), Fluorad FC430 and FC431 (made by Sumitomo 3M Ltd.), W005 (made by Agatos International), Asahi Guard AG710 and Surflon S-382, SC-101, SC-102, SC-103, SC-104, SC-105 and SC-106 (made by Asahi Glass Co., Ltd.), KP341 (made by Shin-Etsu Chemical Co., Ltd.), Polyflow No.75 and No.95 (made by Kyoueisha Chemical Co., Ltd.), and DC-57 (made by Dow Corning Toray Silicone).

As a solvent in the present invention, suitably selectively usable is a solvent which disperses or dissolves the (A) to (F) components and the additive components constituting a radiation-sensitive composition, does not react with these components, and has an adequate volatility.

These solvents include, for example:
(poly)alkylene glycol monoalkyl ethers such as ethylene glycol monomethyl ether, ethylene glycol monoethyl ether, ethylene glycol mono-n-propyl ether, ethylene glycol mono-n-butyl ether, diethylene glycol monomethyl ether, diethylene glycol monoethyl ether, diethylene glycol mono-n-propyl ether, diethylene glycol mono-n-butyl ether, triethylene glycol monomethyl ether, triethylene glycol monoethyl ether, propylene glycol monomethyl ether, propylene glycol monoethyl ether, propylene glycol mono-n-propyl ether, propylene glycol mono-n-butyl ether, dipropylene glycol monomethyl ether, dipropylene glycol monoethyl ether, dipropylene glycol mono-n-propyl ether, dipropylene glycol mono-n-butyl ether, tripropylene glycol monomethyl ether and tripropylene glycol monoethyl ether;

(poly)alkylene glycol monoalkyl ether acetates such as ethylene glycol monomethyl ether acetate, ethylene glycol monoethyl ether acetate, diethylene glycol monomethyl ether acetate, diethylene glycol monoethyl ether acetate, propylene glycol monomethyl ether acetate and propylene glycol monoethyl ether acetate;
other ethers such as diethylene glycol dimethyl ether, diethylene glycol methyl ethyl ether, diethylene glycol diethyl ether and tetrahydrofuran;
ketones such as methyl ethyl ketone, cyclohexanone, 2-heptanone and 3-heptanone;

alkyl lactates such as methyl lactate and ethyl lactate;
other esters such as ethyl 2-hydroxy-2-methylpropionate, methyl 3-methoxypropionate, ethyl 3-methoxypropionate, methyl 3-ethoxypropionate, ethyl 3-ethoxypropionate, ethyl ethoxyacetate, ethyl hydroxyacetate, methyl 2-hydroxy-3-methylbutanoate, 3-methoxybutyl acetate, 3-methyl-3-methoxybutyl acetate, 3-methyl-3-methoxybutyl propionate, ethyl acetate, n-propyl acetate, i-propyl acetate, n-butyl acetate, i-butyl acetate, n-amyl formate, i-amyl acetate, n-butyl propionate, ethyl butylate, n-propyl butyrate, i-propyl butyrate, n-butyl butyrate, methyl pyruvate, ethyl pyruvate, n-propyl pyruvate, methyl acetoacetate, ethyl acetoacetate and ethyl 2-oxobutanoate;
aromatic hydrocarbons such as toluene and xylene; and
amides or lactams such as N,N-dimethylformamide, N,N-dimethylacetamide and N-methylpyrrolidone.

Among these solvents, in view of the solubility, pigment dispersibility, coatability and the like, preferable are propylene glycol monomethyl ether, propylene glycol monoethyl ether, ethylene glycol monomethyl ether acetate, propylene glycol monomethyl ether acetate, propylene glycol monoethyl ether acetate, diethylene glycol dimethyl ether, diethylene glycol methyl ethyl ether, cyclohexanone, 2-heptanone, 3-heptanone, ethyl lactate, ethyl 3-methoxypropionate, methyl 3-ethoxypropionate, ethyl 3-ethoxypropionate, 3-methoxybutyl acetate, 3-methyl-3-methoxybutyl propionate, n-butyl acetate, i-butyl acetate, n-amyl formate, i-amyl acetate, n-butyl propionate, ethyl butylate, i-propyl butyrate, n-butyl butyrate and ethyl pyruvate.
The solvents may be used singly or as a mixture of two or more.

Concurrently with the above-mentioned solvents, high-boiling point solvents can be used, such as benzyl ethyl ether, di-n-hexyl ether, acetonylacetone, isophorone, caproic acid, caprylic acid, 1-octanol, 1-nonanol, benzyl alcohol, benzyl acetate, ethyl benzoate, diethyl oxalate, diethyl maleate, γ-butyrolactone, ethylene carbonate, propylene carbonate and ethylene glycol monophenyl ether acetate.
These high-boiling point solvents may be used singly or as a mixture of two or more.

The using amount of the solvent is not especially limited, but in view of the coatability, stability and the like of the obtained radiation-sensitive composition, the using amount is desirably such that the total concentration of the components except a solvent in the composition is usually 5 to 50% by weight, preferably 10 to 40% by weight.

The radiation-sensitive composition of the present invention can be prepared by a suitable method, but is usually prepared by mixing and dispersing while pulverizing (A) the pigment in a solvent under the presence of (B) the dispersant by using, for example, a bead mill or a roll mill to make a pigment liquid dispersion, and adding thereto and mixing therewith the (C) component, (D) component, (E) component and (F) component, and optionally additional solvents and other additives.

Then, a method will be described in which the color filter of the present invention is formed by using the radiation-sensitive composition of the present invention for forming a color filter for a solid-state image sensing device (hereinafter, simply referred to also as "radiation-sensitive composition").
The method of the present invention for forming the color filter for the solid-state image sensing device includes at least the steps (1) to (4) described below:
(1) a step of forming a film of the radiation-sensitive composition of the present invention on a substrate;
(2) a step of exposing at least a part of the film with radiation;
(3) a step of developing the film after the exposure; and
(4) a step of post-baking the film after the development.

Hereinafter, these steps will be described in turn.

### - Step (1) -

First, a light shielding layer is formed on the surface of a substrate so as to zone a part for forming pixels, as required; the radiation-sensitive composition of the present invention is applied on the substrate, and then pre-baked to evaporate a solvent to form a film.

The substrate used in this step includes, for example, silicon and silicon nitride.
The substrate may have been subjected, as desired, to a suitable pretreatment such as chemicals treatment with hexamethylenesilazane, a silane coupling agent and the like, plasma treatment, ion plating, sputtering, vapor phase reaction or vacuum deposition.
When the radiation-sensitive composition is applied on a substrate, the coating method using a spin coater of an automatic coating and developing apparatus is preferable.
The prebaking condition is preferably 70 to 110°C for about 2 to 4 min.
The coating thickness as a film thickness after drying is preferably 0.1 to 5.0 µm, more preferably 0.2 to 3.0 µm, still more preferably 0.2 to 2.0 µm.

### - Step (2) -

Then, at least a part of the formed film is exposed to radiation. In this step, when a part of the film is exposed, the exposure is preferably performed through a photomask having a predetermined pattern using a reduced projection exposure machine.
As radiation used for exposure, radiation, such as visible light, ultraviolet light, far ultraviolet light, electron beams and X-rays, can be suitably selectively used. Radiation of a wavelength in the range of 190 to 450 nm is preferable.
The exposure amount of radiation is preferably about 100 to 10,000 J/m².

### - Step (3) -

Then, the film after the exposure is developed by using a liquid developer, preferably an alkali liquid developer; and unexposed parts of the film are dissolved and removed to form a predetermined pattern.
The alkali liquid developer is preferably an aqueous solution of sodium carbonate, sodium hydroxide, potassium hydroxide, tetramethylammonium hydroxide, choline, 1,8-diazabicyclo[5.4.0]-7-undecene or 1,5-diazabicyclo [4.3.0]-5-nonene.
To the alkali liquid developer, for example, an aqueous organic solvent such as methanol or ethanol, a surfactant, and the like may be added in suitable amounts. The film after alkali developing is preferably rinsed with water.
Applicable development treatment methods include shower development, spray development, dip (immersion) development and paddle (liquid piling) development.
The developing condition is at ordinary temperature for about 5 to 300 sec.

### - Step (4) -

Then, the film after the development is post-baked to obtain a substrate on which a pixel pattern is arranged in a predetermined arrangement.
The post-baking treatment condition is preferably, for example, at 180 to 240°C for about 15 to 90 min. The film thickness of the pixels thus formed is preferably 0.1 to 6.0 µm, more preferably 0.5 to 3.0 µm.
By repeating the steps (1) to (4) by using each of the radiation-sensitive compositions having a red pigment, a green pigment and a blue pigment dispersed, respectively, pixel patterns of red, green and blue are formed on the same substrate to form on the substrate a colored layer in which pixel patterns of three primary colors of red, green and blue are arranged in a predetermined arrangement.
In the present invention, the forming order of pixel patterns of each color can be optionally selected.

The color filter for the solid-state image sensing device of the present invention is formed from the radiation-sensitive composition of the present invention.
The color filter for the solid-state image sensing device of the present invention is remarkably useful for a transmission-type or reflection-type solid-state image sensing device.

The solid-state image sensing device of the invention is equipped with the color filter of the present invention.

### Examples

Hereinafter, the present invention will be described more specifically by way of examples. However, the present invention is not limited to Examples below.

### Synthesis of alkali-soluble resins

### Synthesis Example 1

3 parts by weight of 2,2'-azobisisobutyronitrile and 200 parts by weight of propylene glycol monomethyl ether acetate were charged in a flask equipped with a cooling tube and a stirrer; and successively to the mixture, 10 parts by weight of methacrylic acid, 25 parts by weight of benzyl methacrylate, 11 parts by weight of styrene, 19 parts by weight of N-phenylmaleimide, 5 parts by weight of glycerol monomethacrylate, 30 parts by weight of ω-carboxy-polycaprolactone monoacrylate, and 5 parts by weight of α-methylstyrene dimer as a molecular weight controlling agent were charged; and the atmosphere of the flask was replaced by nitrogen. Then, the temperature of the reaction solution was raised to 80°C under gentle stirring, and the temperature was held for 5 hours for polymerization to obtain a solution of a copolymer (C-1). (Mw=10,000, Mn=6,000, solid content concentration: 31.2% by weight)

### Synthesis Example 2

3 parts by weight of 2,2'-azobisisobutyronitrile and 200 parts by weight of propylene glycol monomethyl ether acetate were charged in a flask equipped with a cooling tube and a stirrer; and successively to the mixture, 15 parts by weight of methacrylic acid, 35 parts by weight of benzyl methacrylate, 11 parts by weight of styrene, 19 parts by weight of N-phenylmaleimide, 10 parts by weight of glycerol monomethacrylate, 10 parts by weight of ω-carboxy-polycaprolactone monoacrylate, and 5 parts by weight of α-methylstyrene dimer as a molecular weight controlling agent were charged; and the atmosphere of the flask was replaced by nitrogen. Then, the temperature of the reaction solution was raised to 80°C under gentle stirring, and the temperature was held for 5 hours for polymerization to obtain a solution of a copolymer (C-2). (Mw=10,500, Mn=5,200, solid content concentration: 31.2% by weight)

### Synthesis Example 3

3 parts by weight of 2,2'-azobisisobutyronitrile and 200 parts by weight of propylene glycol monomethyl ether acetate were charged in a flask equipped with a cooling tube and a stirrer; and successively to the mixture, 20 parts by weight of methacrylic acid, 10 parts by weight of benzyl methacrylate, 12 parts by weight of styrene, 15 parts by weight of N-phenylmaleimide, 15 parts by weight of 2-hysroxyethyl methacrylate, 28 parts by weight of 2-ethylhexyl methacrylate, and 5 parts by weight of α-methylstyrene dimer as a molecular weight controlling agent were charged; and the atmosphere of the flask was replaced by nitrogen. Then, the temperature of the reaction solution was raised to 80°C under gentle stirring, and the temperature was held for 5 hours for polymerization to obtain a solution of a copolymer (C-3). (Mw=10,200, Mn=5,200, solid content concentration: 31.4% by weight)

### Preparation of pigment-dispersed liquids

### Preparation Example 1

15 parts by weight of a mixture, as (A) a pigment, of C.I. Pigment Red 254/C.I. Pigment Red 177/C.I. Pigment Red 139 in a ratio of 32/48/20 (by weight), 4 parts by weight (in terms of solid content) of Disperbyk-2001 as a dispersant, 16 parts by weight of the copolymer (C-1) solution, and 42 parts by weight of propylene glycol monomethyl ether acetate and 18 parts by weight of propylene glycol monoethyl ether as solvents, were treated with a bead mill to prepare a red pigment-dispersed liquid (R1).

### Preparation Example 2

A red pigment-dispersed liquid (R2) was prepared as in Preparation Example 1, except for using 15 parts by weight of a mixture, as (A) a pigment, of C.I. Pigment Red 254/C.I. Pigment Red 139 in a ratio of 80/20 (by weight) in place of the mixture of C.I. Pigment Red 254/C.I. Pigment Red 177/C.I. Pigment Red 139 in a ratio of 32/48/20.

### Preparation Example 3

18 parts by weight of a mixture, as (A) a pigment, of C.I. Pigment Green 36/C.I. Pigment Yellow 139 in a ratio of 75/25 (by weight), 5 parts by weight (in terms of solid content) of Disperbyk-2001 as a dispersant, 16 parts by weight of the copolymer (C-2) solution, and 58 parts by weight of propylene glycol monomethyl ether acetate as a solvent, were treated with a bead mill to prepare a green pigment-dispersed liquid (G1).

### Preparation Example 4

A green pigment-dispersed liquid (G2) was prepared as in Preparation Example 3, except for using 18 parts by weight of a mixture, as (A) a pigment, of C.I. Pigment Green 36/C.I. Pigment Yellow 150/C.I. Pigment Yellow 83/C.I. Pigment Yellow 139 in a ratio of 75/8/3/14 (by weight) in place of the mixture of C.I. Pigment Green 36/C.I. Pigment Yellow 139 in a ratio of 75/25 (by weight).

### Preparation Example 5

18 parts by weight of a mixture, as (A) a pigment, of C.I. Pigment Green 36/C.I. Pigment Yellow 139 in a ratio of 75/25 (by weight), 5.5 parts by weight of Solsperse S24000 (amine value: 50, acid value: 25) as a dispersant, 16 parts by weight of the copolymer (C-2) solution, and 64 parts by weight of propylene glycol monomethyl ether acetate as a solvent, were treated with a bead mill to prepare a green pigment-dispersed liquid (G3).

### Preparation Example 6

12 parts by weight of a mixture, as (A) a pigment, of C.I. Pigment Blue 15:6/C.I. Pigment Violet 23 in a ratio of 85/15 (by weight), 4.5 parts by weight (in terms of solid content) of Disperbyk-2001 as a dispersant, 12.8 parts by weight of the copolymer (C-1) solution, and 49 parts by weight of propylene glycol monomethyl ether acetate and 16 parts by weight of propylene glycol monoethyl ether as solvents, were treated with a bead mill to prepare a blue pigment-dispersed liquid (B1).

### Preparation Example 7

A blue pigment-dispersed liquid (B2) was prepared as in Preparation Example 6, except for altering the weight ratio of C.I. Pigment Blue 15:6/C.I. Pigment Violet 23 of 85/15 as (A) a pigment to the weight ratio thereof of 92.5/7.5.

### Example 1

573.0 parts by weight of the pigment-dispersed liquid (R1) as a pigment, 86.0 parts by weight of the copolymer (C-2) as (C) the alkali-soluble liquid, 37.0 parts by weight of dipentaerythritol hexaacrylate as (D) the polyfunctional monomer, 9.0 parts by weight of 2-benzyl-2-dimethylamino-1-(4-morpholinophenyl)butan-1-one, 1,2-octanedione as (E) the photopolymerization initiator, 0.5 parts by weight of phenothiazine as the (F) component, 0.6 parts by weight of citraconic acid and 0.3 parts by weight of a surfactant F-475 made by Dainippon Ink & Chemicals, Inc., as additives, and 290.0 parts by weight of propylene glycol monomethyl ether acetate as a solvent, were mixed to prepare a red liquid composition (R-1). The kind and amount of each component of the liquid composition are shown in Table 1 (numerical values in the table denote parts by weight).

With respect to the liquid composition (R-1), a pattern was formed and evaluated according to the following procedures. The evaluation results are shown in Table 2.

### Formation of pattern

The liquid composition (R-1) was applied on a 6-inch silicon wafer surface having been treated with hexamethylene silazane (HMDS) by using an automatic coating and developing apparatus (Clean Track MARKVIII, made by Tokyo Electron Ltd.), and then pre-baked at 90°C for 150 sec to form a coated film of 0.9 µm in thickness. Thereafter, the obtained substrate was cooled to room temperature; and the coated film on the substrate was exposed through a photomask (having a dot pattern or a checkered pattern of 1.0 to 10.0 µm) to ultraviolet light of 365 nm in wavelength (i line) in an exposure amount of 500 to 3,500 mJ/m² at 100 mJ/m² intervals by using a reduced projection exposure machine (NSR-2205i12D, made by Nikon Corp., lens numerical aperture: 0.48). Then, the exposed film was subjected to a paddle (liquid piling) development with a 0.05-wt.% tetramethylammonium hydroxide aqueous solution for 90 sec, rinsed with ultrapure water, spin-dried, and then post-baked on a hot plate at 180°C for 300 sec to form a dot pattern (left in FIG. 1) or a checkered pattern (right in FIG. 1).

### Evaluation of film remaining rate

With respect to the dot pattern of 10.0 µm formed in an exposure amount of 1,000 J/m², the film thickness after the exposure and the film thickness after the post-baking were measured with a scanning electron microscope; and the film remaining rate (%) was calculated from the expression below.
Film remaining rate (%)=film thickness after post-baking/film thickness after exposure × 100
If the film remaining rate (%) was less than 70%, the film had a high possibility of deficient curing; and sublimating substances were generated, and there was a risk of contaminating the post-baking furnace.

### Evaluation of the adequate exposure amount and the resolution

The exposure amount when a dot pattern formed through a photomask of a dot pattern (or a checkered pattern) of 1.5 µm has a size of 1.5 µm in width, was defined as an adequate exposure amount. Here, for the red liquid composition and the blue liquid composition, a dot pattern was formed and evaluated; and for the green liquid composition, a checkered pattern was formed and evaluated. The adequate exposure amount was preferably in the range of 1,000 J/m² to 3,000 mJ/cm². With the adequate exposure amount of less than 1,000 J/m², a reduced projection exposure machine having a high illuminance could not precisely control the exposure shutter; by contrast, with that exceeding 3,000 J/cm², the throughput remarkably dropped; therefore, either case was not suitable for the mass production of a color filter for a solid-state image sensing device.
A dot pattern (or a checkered pattern) of 1.50 µm by the adequate exposure amount was observed with a scanning electron microscope, and a result in which the pattern was well resolved with no peeling and deformation was defined as "A" as the evaluation of resolution; and a result in which the pattern was observed to exhibit peeling and deformation was defined as "C".

### Evaluation of residues

With respect to the substrate used in the above-mentioned resolution evaluation, unexposed parts on edge parts and peripheries of a dot pattern (or a checkered pattern) of 1.50 µm were observed with a scanning electron microscope, and a case where no residues were observed was defined as "A"; a case where residues were slightly observed was defined as "B"; and a case where residues were heavily observed was defined as "C".

### Examples 2 to 22 and Comparative Examples 1 to 4

Liquid compositions were prepared and evaluated as in Example 1, except for that the kind and amount of each component of each liquid component was as shown in Table 1 (numerical values in the table denote parts by weight). The evaluation results are shown in Table 2.

In Table 1, the details of a solvent, a polyfunctional monomer, photopolymerization initiators, an F component, a polymerization inhibitor other than the F component (hereinafter, also referred to as "another polymerization inhibitor") and additives are as follows.

### Solvent

PGMEA: Propylene glycol monomethyl ether acetate

### Polyfunctional monomer

D1: Dipentaerythritol hexaacrylate

### Photopolymerization initiator

E1: 2-benzyl-2-dimethylamino-1-(4-morpholinophenyl)butan-1-one, 1,2-octanedione (trade name: Irgacure 369, made by Ciba Speciality Chemicals Corp.)
E2: 1-[9-ethyl-6-(2-methylbenzoyl)-9H-carbazole-3-yl]-ethanone 1-(O-acetyloxime) (trade name: Irgacure OXE02, made by Ciba Speciality Chemicals corp.)
E3: 2,4-diethylthioxanthone (trade name: KAYACURE DETX-S, Nippon Kayaku Co., Ltd.)

### (F) Component

F1: Phenothiazine (made by Seiko Chemical Co., Ltd.)

### Another polymerization inhibitor

H1: 4-methoxyphenol (made by Seiko Chemical Co., Ltd.)

### Additives

J1: Citraconic acid (made by Wako Pure Chemical Industries, Ltd.)
J2: Malonic acid (made by Wako Pure Chemical Industries, Ltd.)
J3: Surfactant F-475 (made by Dainippon Ink & Chemicals, Inc.)
J4: Surfactant FTX-2180 (made by Neos Co., Ltd.)
J5: Surfactant PF-636 (made by Omnova Solutions Inc.)
J6: Surfactant W005 (made by Agatos International)

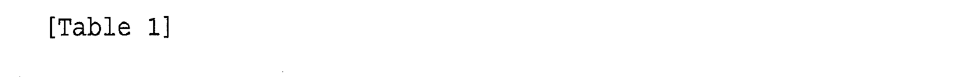

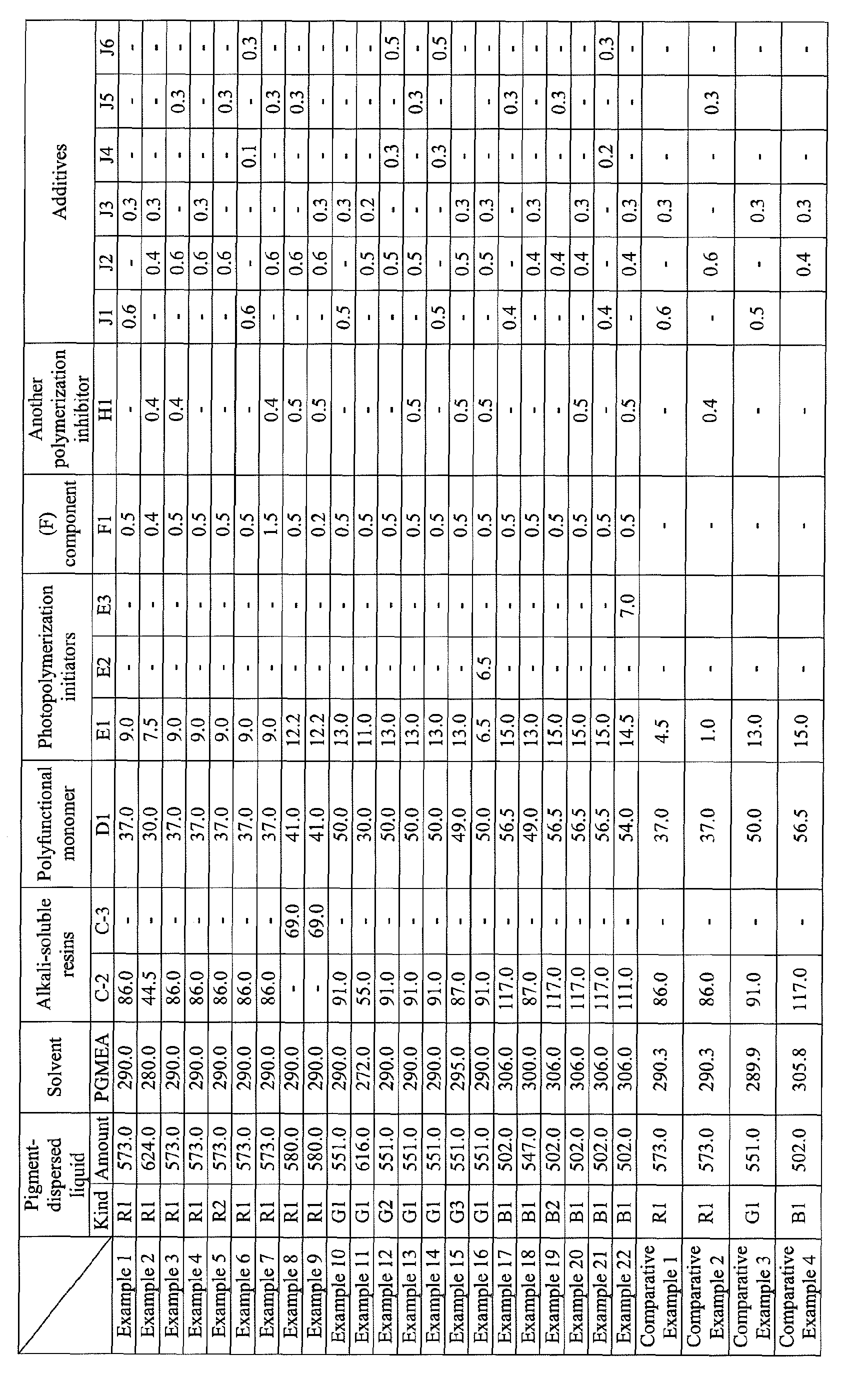

**[Table 2]**

| | Film remaining rate (%) rate (%) | Adequate exposure amount | Resolution | Residue |
|---|---|---|---|---|
| Example 1 | 90% | 1200 J/m² | A | A |
| Example 2 | 89% | 1300 J/m² | A | A |
| Example 3 | 90% | 1300 J/m² | A | A |
| Example 4 | 90% | 1200 J/m² | A | A |
| Example 5 | 90% | 1300 J/m² | A | A |
| Example 6 | 90% | 1200 J/m² | A | A |
| Example 7 | 72% | 3400 J/m² | A | A |
| Example 8 | 85% | 1200 J/m² | A | A |
| Example 9 | 84% | 1000 J/m² | A | A |
| Example 10 | 83% | 2000 J/m² | A | A |
| Example 11 | 82% | 1900 J/m² | A | A |
| Example 12 | 82% | 2000 J/m² | A | A |
| Example 13 | 82% | 2100 J/m² | A | A |
| Example 14 | 82% | 2000 J/m² | A | A |
| Example 15 | 81% | 3000 J/m² | A | B |
| Example 16 | 84% | 1050 J/m² | A | A |
| Example 17 | 89% | 2500 J/m² | A | A |
| Example 18 | 88% | 2550 J/m² | A | A |
| Example 19 | 89% | 2500 J/m² | A | A |
| Example 20 | 89% | 2550 J/m² | A | A |
| Example 21 | 89% | 2450 J/m² | A | A |
| Example 22 | 84% | 2000 J/m² | A | A |
| Comparative Example 1 | 65% | 500 J/m² | C | B |
| Comparative Example 2 | 47% | 1000 J/m² | C | B |
| Comparative Example 3 | 80% | no exposure | - | C |
| Comparative Example 4 | 89% | 700 J/m² | A | B |

As is clear from Table 1 and Table 2, use of (A) the pigment, (B) the dispersant, (C) the alkali-soluble resin, (D) the polyfunctional monomer, (E) the photopolymerization initiator, and additionally (F) the polymerization inhibitor represented by the formula (1) enables the formation of a color filter excellent in resolution without generating residues and scumming on a silicon substrate. By contrast, it is found that in the case of using a polymerization inhibitor other than the formula (1), residues are generated on a substrate, and a color filter with a low resolution is formed.
There is provided a radiation-sensitive composition for forming a color filter used for a solid-state image sensing device excellent in resolution without generating residues and scumming on a silicon substrate or a silicon nitride substrate. The radiation-sensitive composition for forming the color filter for the solid-state image sensing device contains (A) a pigment, (B) a dispersant, (C) an alkali-soluble resin, (D) a polyfunctional monomer, (E) a photopolymerization initiator, and (F) a compound represented by the following formula (1): 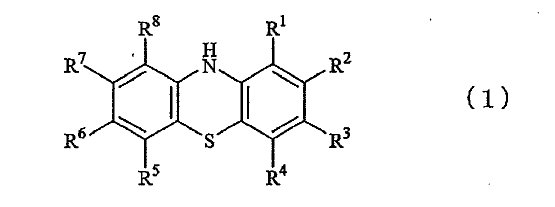 wherein R¹ to R⁸ each denote independently a hydrogen atom, a halogen atom or a monovalent organic group. There is provided a color filter using the composition.

## Claims

1. A radiation-sensitive composition for forming a color filter for a solid-state image sensing device, the composition comprising (A) a pigment, (B) a dispersant, (C) an alkali-soluble resin, (D) a polyfunctional monomer, (E) a photopolymerization initiator, and (F) a compound represented by the following formula (1): 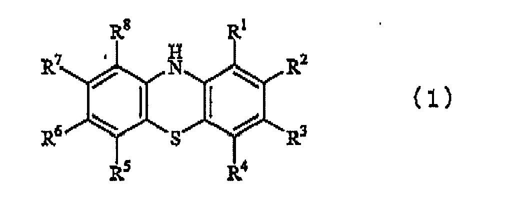 wherein R¹ to R⁸ each denote independently a hydrogen atom, a halogen atom or a monovalent organic group.

2. The radiation-sensitive composition according to claim 1, wherein a content of (F) the compound is 0.1 to 10 parts by weight, with respect to 100 parts by weight of (E) the photopolymerization initiator.

3. The radiation-sensitive composition according to claim 1 or 2, wherein an amine value of (B) the dispersant is 30 to 90 mgKOH/g and an acid value thereof is 20 to 80 mgKOH/g.

4. A color filter formed from the radiation-sensitive composition according to any one of claims 1 to 3.

5. A method for forming a color filter for a solid-state image sensing device, comprising at least the following steps in order thereof:
forming a film of the radiation-sensitive composition according to any one of claims 1 to 3 on a silicon substrate or a silicon nitride substrate;
exposing at least a part of the film with radiation;
developing the film after the exposure; and
post-baking the film after the development.

6. A solid-state image sensing device comprising the color filter according to claim 4.
